Europäisches Patentamt

European Patent Office

Office européen des brevets

(11) Publication number: 0 095 877
B1

# (12) EUROPEAN PATENT SPECIFICATION

(45) Date of publication of patent specification: 15.01.86

(51) Int. Cl.⁴: **H 01 R 13/193,** H 01 R 23/68

(21) Application number: 83302926.7

(22) Date of filing: 23.05.83

(54) An electrical connector.

(30) Priority: 02.06.82 US 384359

(43) Date of publication of application:
07.12.83 Bulletin 83/49

(45) Publication of the grant of the patent:
15.01.86 Bulletin 86/03

(84) Designated Contracting States:
BE DE FR GB IT NL SE

(56) References cited:
EP-A-0 043 199
EP-A-0 050 442
US-A-3 915 537

IBM TECHNICAL DISCLOSURE BULLETIN,
vol.22, no.2, July 1979, New York, B.E. BLAKE
et al.: "Actuating mechanism for high-density
multilayer ceramic module", pages 567-570.

(73) Proprietor: AMP INCORPORATED
P.O. Box 3608 449 Eisenhower Boulevard
Harrisburg Pennsylvania 17105 (US)

(72) Inventor: Bright, Edward John
R.D. No. 1 Box 8C
Elizabethtown Pennsylvania 17022 (US)
Inventor: Marpoe, Gary Ray, Jr.
533 West High Street
Hummelstown Pennsylvania 17036 (US)
Inventor: Schuemann, Klaus Dieter
125 Belglen Way
Los Gatos California 95030 (US)
Inventor: Sheesley, Wilmer Lee
R.D. No. 2 Red Hill Road
Dauphin Pennsylvania 17018 (US)

(74) Representative: Gray, Robin Oliver et al
BARON & WARREN 18 South End Kensington
London W8 5BU (GB)

Courier Press, Leamington Spa, England.

## Description

There is described in US Patent No. 3 915 537 a zero or low insertion force, low actuation force connector or contact element for receiving pin grid substrate pins as well as other types of leads on electronic devices. This contact element comprises a bifurcated spring yoke having a pair of inwardly extending arms. Contact surfaces are provided on the arms on opposing faces. The pins or leads are either slid in between the arms from a side or from above. A bevelled portion on the contact surfaces provide a zero insertion force when the pin is introduced into the contact element from the side. The shape of the contact surfaces and resiliency of the arms provide a low insertion force when the pin is inserted from above.

The contact elements may be housed in recesses in a base. The recesses have a length such that the pins can be first inserted into the recesses and then the substrate or other electronic package moved along the surface of the base to push the pins in between the arms and contact surfaces thereon.

EP—A—0043199 discloses a zero insertion force connector comprising a housing having a plurality of cavities in which are positioned contact elements having a pair of arms extending from opposite sides of a channel shaped strap portion, one arm having a finger extending laterally of the arm at its free end opposed to an end portion of the other arm whereby on interposition of a pin or lead between the finger and opposed end portion effects torsional deflection of the one arm about an axis extending longitudinally of the channel shaped strap portion.

A connector having the aforesaid features according to the invention is characterised in that the arms extend in parallel spaced manner from the opposite sides of the channel shaped strap portion, the arms being inclined in a direction away from the strap portion towards the base of the channel, and at their free ends each being formed with a respective finger extending laterally of and from the arms in a direction away from the base of the channel shaped strap portion whereby on insertion of the pin or lead between opposed free end portions of the fingers to deflect the end portions apart, the arms are subject to torsion about axes extending longitudinally of the channel shaped strap portion.

Suitably the free ends of the fingers are parallel to one another and the sections of the fingers between the free ends and arms converge towards the free ends.

Preferably the width of the two arms decreases upwardly towards the upper free ends thereof.

EP—A—0050442 discloses a zero insertion force connector in which the contact elements comprise a pair of arms extending from adjacent sides of a box-section strap portion, one of the arms having a lateral finger at its free end and opposed to a bent over end portion of the other arm, whereby on interposition of a pin or lead between the free end of the finger and the opposed bent over portion effects torsion of the one arm and of the box section about an axis extending longitudinally of the box section. The one arm is of uniformly reducing width in a direction away from the box section.

The state of the art is further exemplified by US Patent Nos. 3 763 459; 3 594 698 and 2 982 883.

For a better understanding of the invention, reference will now be made by way of example of the accompanying drawings, in which:—

Figure 1 is an isometric view of a pin grid substrate, a printed circuit board and the ZIF (zero insertion force) connector of the present invention for electrically interconnecting the two;

Figure 2 is an isometric view of a contact element forming a part of the connector of the present invention:

Figure 3 is a blanked-out contact element of Figure 2 prior to being formed;

Figure 4 is a cross-sectional view showing the contact element of Figure 2 positioned in a cavity in the connector of Figure 1 mounted on a circuit board and with a substrate on the connector with a pin extending into the cavity and between the two arms on the contact element;

Figures 5a and 5b are plan views taken along lines 5a and 5b in Figure 4;

Figure 6 is a view corresponding to Figure 4 but with the substrate and pin moved laterally by the connector cover so that the pin is now located between the free ends of fingers on the contact element for electrical connection therewith; and

Figures 7a and 7b are plan views taken along lines 7a and 7b in Figure 6.

The invention disclosed herein is a connector which is mounted on a printed circuit board or the like and on which an electronic device can be mounted, and through which electrical paths are provided to establish links between the electronic components within the device and the circuitry on the board. The electronic device used to demonstrate the utility of the present invention is a pin grid substrate; the inventive connector, however, is not limited to such a device but rather can be used with any other electronic device having pins or leads with but minor changes relating to dimensions and not to changes in the inventive concepts. Accordingly, wherever the term "pin" is used, it is to be understood that "lead" or other like term may be substituted.

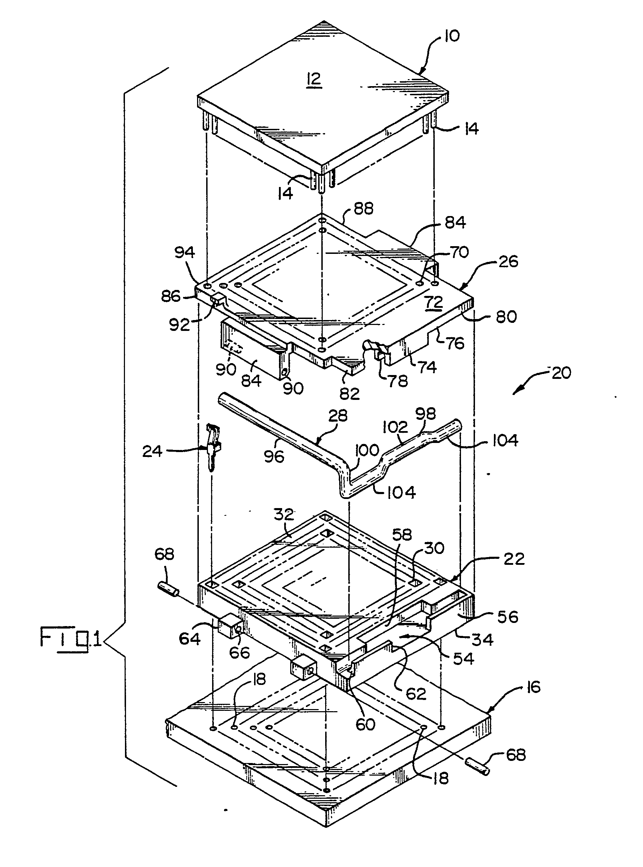

Referring now to Figure 1, pin grid substrate 10 includes a ceramic member 12 from which pins 14 depend. Circuit board 16, located at the bottom of the drawing, contains circuitry connected to plated through holes 18. The connector of the present invention, indicated generally by reference numeral 20 and shown in exploded fashion between substrate 10 and board 16, provides the electrical links between the pins on the substrate and circuitry on the board.

Connector 20 includes housing 22, contact elements 24, cover 26, and lever 28.

Housing 22, molded from a glass filled nylon sold by General Electric Col. under the tradename VALOX 420, carries a number of regularly spaced cavities 30 extending vertically from top surface 32 through underside 34. The cavity structure is clearly shown in Figure 4 to which attention is now directed.

Upper section 36 of the cavity extends from top surface 32 down to a floor 38. The distance between the rear wall 40 and front wall 42 decreases about one-third of the way down from the top surface. A vertical groove 44 is provided in the inwardly projecting portion of the front wall.

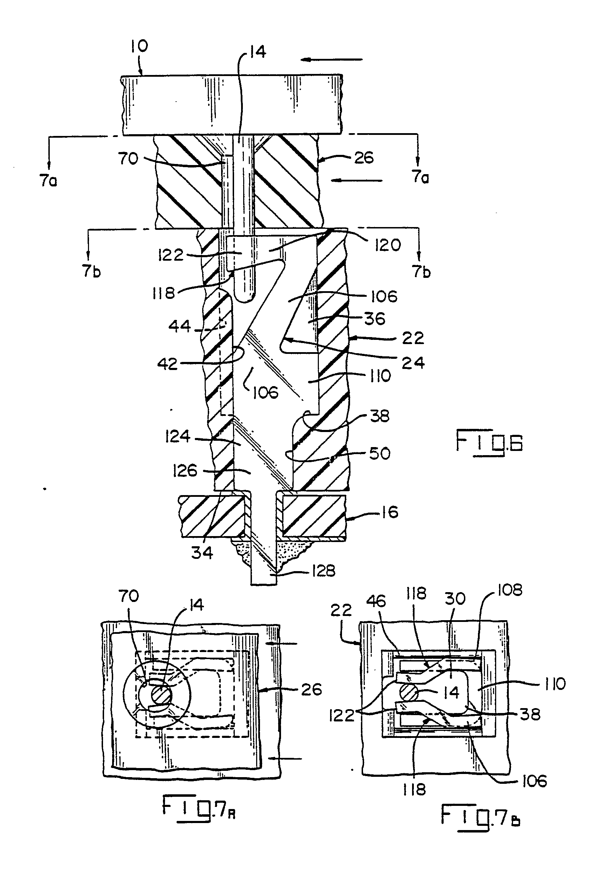

Upwardly facing shoulders 46 (Figure 5b) are provided on both side walls 48 a short distance above floor 38.

Lower section 50 of a cavity 30 is dimensionally of reduced cross-sectional area and length relative to the upper section and extends downwardly from one side of the upper section.

With reference to Figure 1 again, an upwardly opened, lever-receiving groove 54 is provided adjacent end 56 of housing 22. An enlarged portion 58 of the groove, intermediate the ends thereof, accommodates the offset or jog 102 in lever 28. Groove 54 is open at one end 60 to accommodate lever 28.

End wall 56 is notched as indicated by reference numeral 62 to provide room for a depending structure on cover 26.

Two blocks 64 with holes 66 therethrough are located on each side of housing 22. The holes receive roll pins 68. The blocks, holes, and roll pins cooperate with structures on the cover to hold the cover on housing 22.

Cover 26, preferably molded with the same material as the housing, contains vertical openings 70 therethrough in the same number and on the same spacing as cavities 30 in the housing. As shown in Figures 4 and 6, the openings adjacent the cover's top surface 72 may be funneled to facilitate pin entry.

Cam block 74 extends down below the underside surface 76 of the cover and is channeled along its downwardly facing surface as indicated by reference numeral 78. The cam block lies along end 80 of the cover.

One corner of the cover, adjacent end 80 is recessed as indicated by reference numeral 82 to provide room for lever 28.

A block 84 extend downwardly from opposing sides 86 and 88 of the cover. Both blocks are outwardly displaced relating to the upright plane of the sides. Further, the block on side 86 is displaced downwardly, relative to top surface 72, to provide a space for the arm of lever 28. Each block contains an aperture 90 in each end face to receive roll pin 68.

An L-shaped, short member 92 is located adjacent side 86 and towards end 94 of the cover. One section of the member extends outwardly from that side.

Lever 28, a one piece member, includes handle 96 and cam section 98 which is perpendicular to the handle. A short connecting piece 100 joins the handle and cam section and displaces one relative to the other. The cam section includes jog 102 positioned between axles 104.

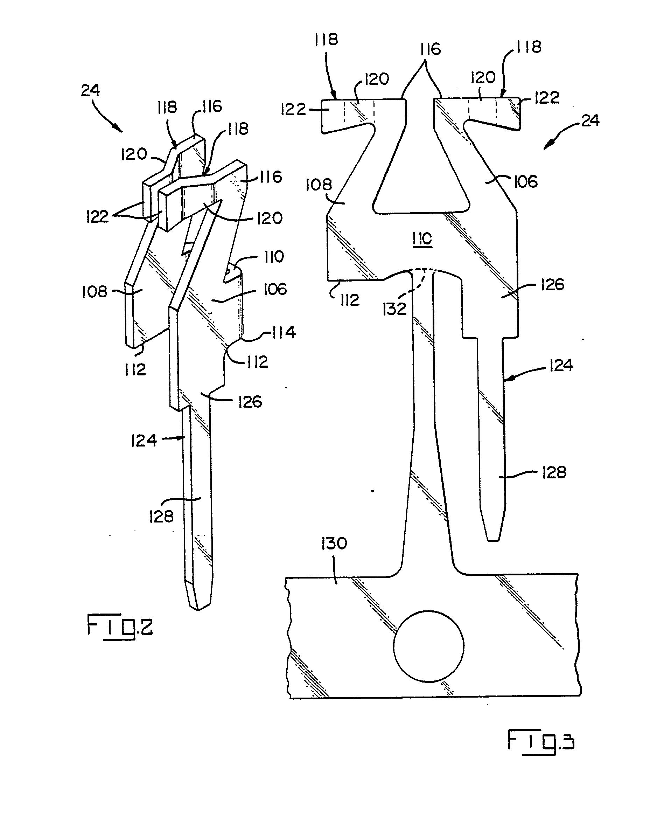

A contact element 24 is shown enlarged in Figure 2 to which reference will now be made.

A contact element 24 comprises two parallel arms 106, 108 extending from opposite sides 112 of a channel shaped strap portion 110 which joins the arms 106, 108 in spaced apart parallel manner, the strap portion 110 providing a downwardly facing shoulder surface 114. The arms extending from an end of the strap portion generally longitudinally thereof and being inclined in a direction away from the strap portion towards the base of the channel to free ends 116 formed with fingers 118 projecting laterally from the arms 106, 108 in a direction away from the base of the channel shaped strap portion 110. First section 120 of the fingers 118 adjacent the arms converge in a direction away from the arms 106, 108 and free end portions 122 extend from the convergent sections in spaced parallel manner. The widths of the arms 106, 108 decreases uniformly in a direction away from the channel shaped strap portion 110 towards end portions 116 whereby parts of the arms further from the strap portion 110 are more susceptible to twisting about a vertical axis. The arms 106, 108 and fingers 118 define spring members generally of the shape of numeral seven supported in spaced relationship by the channel shaped strap portion 110 with the opposed free end portions 122 spaced apart by a distance less than the minimum diameter of pins 14 on substrate 12, or less than the thickness of a lead, not shown, to be received between them. Thus on movement of a pin 14, or lead laterally from the space between the convergent sections 120 to between the end portions 122 effects deflection of the spring member by twisting of the arms 106, 108 in torsion about axes extending lengthwise of the channel shaped strap portion 110.

Lead 124 extends downwardly from arm 106. The lead includes an upper section 126 and a narrower lower section 128.

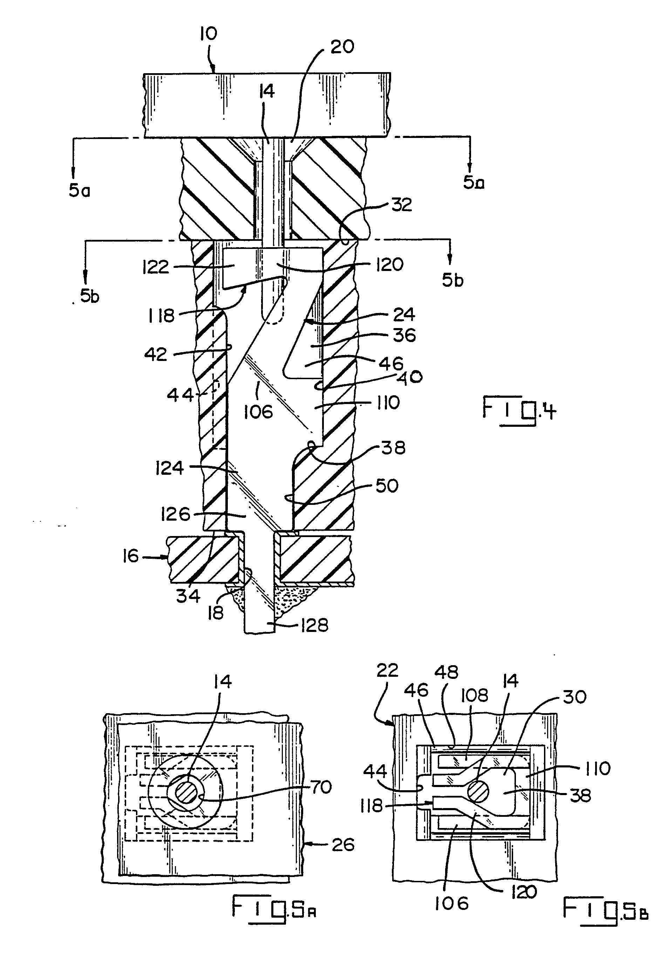

The preferred way of making contact elements 24 is by stamping them out of coplanar stock in a continuous strip. Figure 3 shows one element, attached to carrier strip 130, stamped but not yet formed into the Figure 2 structure. The several parts are identically numbered for cross-reference to the formed element. The dashed line, where the element will be severed from the carrier strip, is indicated by reference numeral 132.

A suitable material for contact elements 14 is copper alloy with suitable plating; e.g., tin lead over nickel.

Contact elements 24 are positioned in cavities 30 as shown in Figure 4. The arms 106 and 108 and fingers 118 occupy upper section 36 with fingers 118 being in the longer portion of that section. Downwardly facing surface 114 on strap 110 and lower ends 112 on the arms rests on floor 38. The lower portion of the arms and strap 110 fit in the lower portion of upper section 36 with substantially no movement. Upper section 126 of lead 124 occupies lower section 50 of the cavity and lower section 128 extends down from housing 22 for insertion into plated through hole 18 in board 16.

After loading contact elements 24 into cavities 30, lever 28 is placed into the housing with jog 102 positioned in enlarged portion 58 of groove 54 and axles 104 in the narrower sections of the groove on either side of portion 58. The connecting piece 100 and handle 96 extend out of the groove through open end 60.

Cover 26 is placed onto top surface 32 so that blocks 84 slide in between blocks 64 and block 74 enters into enlarged portion 58 of notch 62. Jog 102 is received into channel 78 in block 74. The cover is slidably attached to housing 22 by sliding roll pins 68 into holes 66 in blocks 64 and apertures 90 in blocks 84.

The cover is moved back and forth on top surface 32 by pivoting handle 96. As is well understood, jog 102 moves in an arc and, being confined in channel 78, moves the cover. The degree of offset of jog 102 limits the amount of travel imparted to the cover by lever 28. Blocks 64, between which cover blocks 84 move on roll pins 68, define the covers total travel in the horizontal direction.

Figure 4 is a cross-sectional view showing connector 20 with substrate 10 mounted thereon. The cover 26 is positioned so that pin 14 passes through opening 70 and in between arms 106—108 and sections 120 on fingers 118. With these sections of the contact element being spaced apart a distance greater than the pin diameter, there is no resistance in inserting the pin.

Figure 5a is a view from the top of cover 26 showing the pin positioned as described above. This view, and Figure 5b, a view from the top of housing 22, clearly shows pin 14 may be inserted into connector 20 with zero insertion force when cover 26 is in a first position. The view also shows that the free ends 122 of fingers 118 are in a normally closed position which is a non-stressed condition.

By means of lever 28, cover 26 and substrate 10 mounted thereon are moved across the top surface 32 of housing 22. The arrows in Figures 6 and 7b indicate the direction of travel. As the cover moves, the wall defining opening 70 engages pin 14 and moves it in between free ends 122 on fingers 118. Figure 6 is a side elevation, cross-sectional view showing the pin so positioned. As the pin is pushed through converging first sections 120 and into free ends 122, the fingers are spread apart thereby in that the pin diameter is greater than the space between the free ends. Further, arms 106 and 108 are horizontally twisted. Accordingly, considerable compressive and torsional forces keeps free ends 122 bearing hard against pin 14 to achieve and maintain good electrical contact therebetween. The facing surfaces of free ends 122 may be plated with a noble metal to further enhance the electrical contact; e.g., gold over nickel.

Figures 7a and 7b are top plan views showing the Figure 6 condition. Figure 7b particularly shows arms 106 and 108 being twisted as well as free ends 122 spread apart by pin 14 being pushed in between them.

Figure 6 shows that the purpose of vertical groove 44 is to ensure the lower end of pin 14 has room and is not impeded by wall 42.

Lever 28 is designed so that with cover 26 being moved from a Figure 4 first position to a Figure 6 second position, handle 96 lies along the top of block 84 on cover side 86 and is removably latched in under the overhang on member 92 (enough resiliency is available both in the handle and member 92 to allow the handle to pass in under the overhang).

It should be apparent that the connector of the present invention can be modified to accept substantially any electronic device having pins or leads extending therefrom. The modifications need only be relative to dimensions, number of required cavities and the like. No changes to the inventive concepts are necessary.

## Claims

1. An electrical connector comprising a housing (22) having a plurality of cavities (30) in which are positioned contact elements (24) having a pair of arms (106, 108) extending from opposite sides of a channel shaped strap portion, one arm (106) having a finger (118) extending laterally of the arm at its free end opposed to an end portion (122) of the other arm (108) whereby interposition of a pin (14) or lead between the finger (118) and opposed end portion (122) effects torsional deflection of the one arm (106) about an axis extending longitudinally of the channel shaped strap portion (110) characterised in that the arms (106, 108) extend in parallel spaced manner from the opposite sides of the channel shaped strap portion (110), the arms (106, 108) being inclined in a direction away from the strap portion (110) towards the base of the channel, and at their free ends each being formed with a respective finger (118) extending laterally of and from the arm (106, 108) in a direction away from the base of the channel shaped strap portion (110) whereby on insertion of the pin (14) or lead between opposed free end portions (122) of the fingers (118) to deflect the end portions (122) apart, the arms (106, 108) are subject to torsion about axes extending longitudinally of the channel shaped strap portion (110).

2. An electrical connector according to claim 1 characterised in that the free ends (122) of the fingers (118) are parallel to one another and that the sections (120) of the fingers (118) between the free ends (122) and arms (106, 108) converge towards the free ends (122).

3. The electrical connector according to claim 1 or claim 2 characterised in that the width of the two arms (106, 108) decreases upwardly towards the upper free ends (116) thereof.

## Revendications

1. Connecteur électrique comprenant un corps (22) présentant plusieurs cavités (30) dans lesquelles sont positionnés les éléments de contact (24) comportant deux bras (106, 108) qui partent de côtés opposés d'une partie de bride de forme en gouttière, un premier bras (106) comportant un doigt (118) qui part latéralement du bras, à son extrémité libre opposée à une partie extrême (122) de l'autre bras (108) afin qu'une interposition d'une broche (14) ou d'un conducteur entre le doigt (118) et une partie extrême opposée (122) provoque une déformation par torsion du premier bras (106) autour d'un axe s'étendant longitudinalement à la partie (110) de bride en forme de gouttière, caractérisé en ce que les bras (106, 108) partent parallèlement entre eux et à distance l'un de l'autre des côtés opposés de la partie (110) de bride en forme de gouttière, les bras (106, 108) étant inclinés dans une direction s'éloignant de la partie de bride (110) vers la base de la gouttière et étant formés chacun à leur extrémité libre par un doigt correspondant (118) et qui part latéralement du bras (106, 108) dans une direction s'éloignant de la base de la partie de bride (110) en forme de gouttière afin que, lors de l'insertion de la broche (14) ou du conducteur entre les parties extrêmes libres opposées (122) des doigts (118) pour écarter l'une de l'autre les parties extrêmes (122), les bras (106, 108) soient soumis à une torsion autour d'axes s'étendant longitudinalement à la partie de bride (110) en forme de gouttière.

2. Connecteur électrique selon la revendication 1, caractérisé en ce que les extrémités libres (122) des doigts (118) sont parallèles entre elles et en ce que les tronçons (120) des doigts (118) compris entre les extrémités libres (122) et les bras (106, 108) convergent vers les extrémités libres (122).

3. Connecteur électrique selon la revendication 1 ou la revendication 2, caractérisé en ce que la largeur des deux bras (106, 108) diminue vers le haut en direction de leurs extrémités libres supérieures (116).

## Patentansprüche

1. Elektrischer Verbinder mit einem Gehäuse (22), welches eine Vielzahl von Hohlräumen (30) hat, in denen Kontaktelemente (24) angeordnet sind, die ein Paar Arme (106, 108) haben, welche sich von entgegengesetzten Seiten eines rinnenartigen Streifenteils erstrecken, von denen ein Arm (106) an seinem freien Ende einem Endbereich (122) des anderen Arms (108) gegenüber einen Finger (118) hat, der sich seitlich zum Arm erstreckt, wodurch das Dazwischenbringen eines Stiftes (14) oder Leiters zwischen den Finger (118) und den gegenüberliegenden Endbereich (122) eine Torsionsablenkung des einen Arms (106) um eine sich in Längsrichtung des rinnenartigen Streifenteils (110) erstreckende Achse bewirkt, dadurch gekennzeichnet, daß sich die Arme (106, 108) parallel im Abstand voneinander von den entgegengesetzten Seiten des rinnenartigen Streifenteils (110) erstrecken, daß die Arme (106, 108) in Richtung vom Streifenteil (110) weg zum Boden der Rinne geneigt sind, und daß an ihren freien Enden jeweils ein entsprechender Finger (118) ausgebildet ist, der sich seitlich zu den Armen (106, 108) und in Richtung weg vom Boden des rinnenartigen Streifenteils (110) erstreckt, wodurch beim Einsetzen des Stiftes (14) oder Leiters zwischen einander gegenüberliegenden freien Endbereichen (122) der Finger (118) zum Auseinanderbiegen der Endbereiche (122) die Arme (106, 108) einer Torsion um in Längsrichtung des rinnenartigen Streifenteils (110) verlaufende Achsen ausgesetzt sind.

2. Elektrischer Verbinder nach Anspruch 1, dadurch gekennzeichnet, daß die freien Enden (122) der Finger (118) parallel zueinander liegen, und daß die Bereiche (120) der Finger (118) zwischen den freien Enden (122) und Armen (106, 108) zu den freien Enden (122) konvergieren.

3. Elektrischer Verbinder nach Anspruch 1 oder 2, dadurch gekennzeichnet, daß die Breite der beiden Arme (106, 108) nach oben zu den oberen, freien Enden (116) derselben abnimmt.

Fig.1

Fig.2

Fig.3

Fig.4

Fig.5ᴀ

Fig.5ʙ

Fig.6

Fig.7ᴀ

Fig.7ʙ